# EUROPÄISCHE PATENTSCHRIFT

(11) **EP 2 017 869 B1**
(45) Veröffentlichungstag und Bekanntmachung des Hinweises auf die Patenterteilung: **23.06.2010**
(21) Anmeldenummer: 08017537.5
(22) Anmeldetag: 28.07.2006
(51) Int. Cl.: H01H 47/00, G05B 9/03, H01H 9/54, H02P 23/00, H02P 1/28, H03M 1/20

(54) **Sicherheitsvorrichtung zum mehrkanaligen Steuern einer sicherheitstechnischen Einrichtung**
Safety device using multiple channels to control a safety device
Dispositif de sécurité destiné à la commande à plusieurs canaux d'un dispositif de sécurité

(30) Priorität: 02.08.2005 DE 102005036777; 23.09.2005 DE 102005045753; 12.01.2006 DE 102006001805
(43) Veröffentlichungstag der Anmeldung: 21.01.2009
(62) Teilanmeldung aus: 06762897.4
(73) Patentinhaber: Phoenix Contact GmbH & Co. KG, 32825 Blomberg (DE)
(72) Erfinder: Korrek, Andre, 37696 Marienmünster (DE)
(74) Vertreter: Blumbach - Zinngrebe

(56) Entgegenhaltungen:
- EP-A- 1 484 780
- DE-A1- 10 016 712
- DE-A1- 19 707 241
- "NOT-AUS-SCHALTGERAETE, SCHUTZTUERWAECHTER" ANNOUNCEMENT PILZ NSG-D-1-051-07/00, Juli 2000 (2000-07), Seiten 1-4, XP000961973

## Beschreibung

Die Erfindung betrifft eine Sicherheitsvorrichtung zum mehrkanaligen Steuern einer sicherheitstechnischen Einrichtung.

Damit elektrische Antriebe, wie zum Beispiel ein Drehstrommotor, in Anwendungen oder Anlagen als eine sicherheitstechnische Komponente eingesetzt werden können, sind Sicherheitsrelais, Motorschutzschalter oder Motorschutzrelais und Schütze erforderlich, die den Antrieb in einen sicheren Zustand fahren können. Sicherheitsrelais dienen dazu, einen elektrischen Antrieb auszuschalten, sobald ein Notaus-, Schutztür- oder Zweihand-Schalter betätigt worden ist. Motorschutzschalter haben die Aufgabe, zum Beispiel bei thermischer Überlastung den Antrieb mit Hilfe von Bimetallen in einen sicheren Zustand zu fahren. Nachteilig an derartigen Sicherheitsmaßnahmen ist, dass die Bauteile einen großen Platzbedarf und erheblichen Verdrahtungsaufwand erfordern. Dies führt unter Anderem zu hohen Kosten und einem beträchtlichen Wartungsaufwand. Zudem zeigen die eingesetzten elektromagnetischen Schütze einen Kontaktverschleiß. Außerdem besteht die Gefahr, dass bei der Implementierung einer Anlage mit sicherheitstechnischen Komponenten Motorschutzschalter und Sicherheitsrelais falsch an die sicherheitstechnischen Komponenten angeschlossen werden oder defekte Bauteile verwendet werden, so dass die Anlage, der elektrische Antrieb und/oder Bedienpersonen durch einen Fehlbetrieb gefährdet werden können.

Automatisierungsanlagen umfassen in der Regel Feldbussysteme, an die sicherheitstechnische und nicht sicherheitstechnische Aktoren, Sensoren sowie über- und/oder untergeordnete Steuer- und Überwachungseinrichtungen angeschaltet sein können. Ein Aktor kann zum Beispiel einen elektrischen Antrieb, wie zum Beispiel einen Drehstrommotor enthalten. Eine wichtige Anforderung an derartige Automatisierungsanlagen ist, dass bei Auftritt eines Fehlers eine sicherheitstechnische Komponente, z. B. ein Aktor oder sogar die gesamte Automatisierungsanlage in einen gesicherten Zustand gefahren werden kann. Um ein sicheres Abschalten der Automatisierungsanlage oder eines fehlerhaften Aktors zu ermöglichen, muss sichergestellt sein, dass ein definiertes Eingangssignal, welches die Automatisierungsanlage in den sicheren Zustand fahren soll, immer korrekt interpretiert wird.

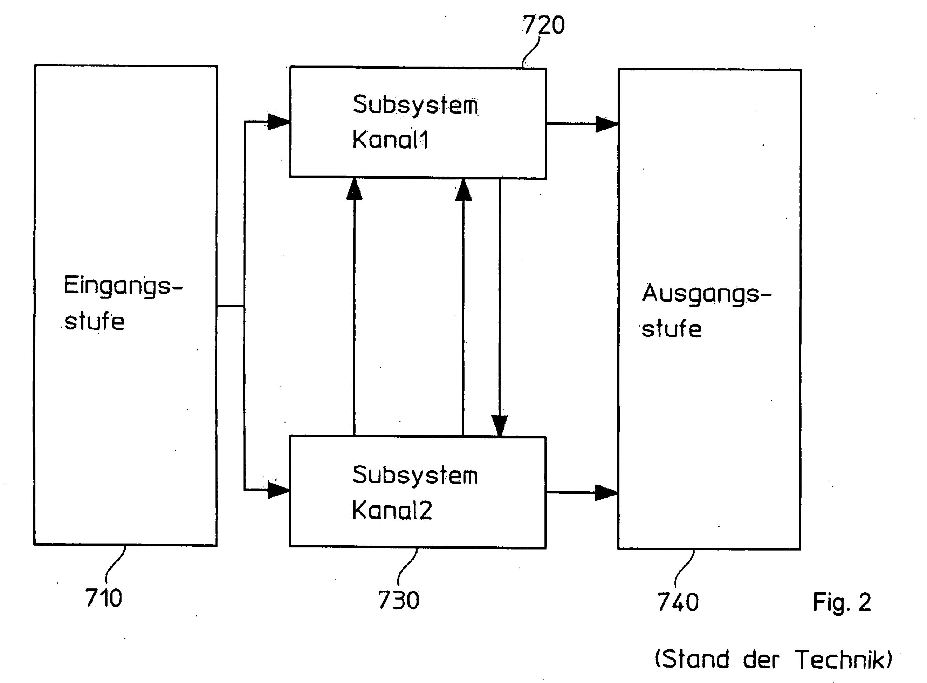

Bei Anlagen und Geräten, die zu einer bestimmten Sicherheitskategorie gehören, werden beispielsweise mehrkanalige Überwachungssysteme verwendet, die unabhängig voneinander arbeitende Subsysteme enthalten, die jeweils für sich die Anlage oder einzelne Geräte in einen gesicherten Zustand fahren können. Die mehrkanaligen oder redundant aufgebauten Überwachungssysteme sind weiterhin derart ausgebildet, dass die Subsysteme die Funktionsfähigkeit des jeweils anderen Subsystems überwachen können. Die gegenseitige Überwachung erfolgt in der Regel durch einen bidirektionalen Austausch von Statusdaten. Derartige bekannte mehrkanalige Überwachungssysteme sind symmetrisch aufgebaut. Das bedeutet, dass ein von einer Eingangsstufe geliefertes Eingangssignal, welches den Betriebszustand einer zu überwachenden Anlage steuert, unmittelbar an den Eingang jedes Subsystems des Überwachungssystems angelegt wird, wie dies in Fig. 2 gezeigt ist.

Ein derartiges Überwachungssystem, welches zwei Kanäle aufweist, ist zum Beispiel aus der DE 197 07 241 A1 benannt. Den Kern dieses Überwachungssystems bilden zwei Mikrocontroller, welche die eigentliche Überwachung und Auswertung ausführen. Die Mikrocontroller sind über bidirektional gerichtete Datenleitungen verbunden, um miteinander kommunizieren und Daten austauschen zu können.

Der Erfindung liegt die Aufgabe zugrunde, eine neuartige Sicherheitsvorrichtung zum mehrkanaligen Steuern einer sicherheitstechnischen Einrichtung, insbesondere einer Automatisierungsanlage, bereitzustellen.

Ein Kerngedanke der Erfindung ist darin zu sehen, dass im Gegensatz zu bestehenden symmetrischen mehrkanaligen Überwachungssystemen, nachfolgend auch Sicherheitsvorrichtung genannt, bei denen das von einer Eingangsstufe bereitgestellte Eingangssignal unmittelbar an jedes Subsystem angelegt wird, das Eingangssignal in einer vorbestimmten Weise moduliert und anschließend den Subsystemen, nachfolgend auch Steuereinrichtungen genannt, zugeführt wird. Insbesondere erfolgt bei der erfindungsgemäßen Sicherheitsvorrichtung keine gegenseitige Überwachung der verschiedenen Steuereinrichtungen. Statt dessen fungiert eine mikroprozessorgesteuerte Steuereinrichtung als Master, welche die andere Steuereinrichtung, welche als Slave betrieben wird, überwacht.

Danach ist eine Sicherheitsvorrichtung zum mehrkanaligen Steuern einer sicherheitstechnischen Einrichtung vorgesehen. An dieser Stelle sei darauf hingewiesen, dass es sich bei einer sicherheitstechnischen Einrichtung um einen Aktor einer Automatisierungsanlage, eine ausführbare sicherheitstechnische Anwendung und/oder um eine Automatisierungsanlage selbst handeln.

Hierzu ist eine erste, mikroprozessorgesteuerte Steuereinrichtung vorgesehen, die einen ersten sogenannten Steuerkanal bildet. Die erste, mikroprozessorgesteuerte Steuereinrichtung weist eine Signalerzeugungseinrichtung zum Erzeugen eines Überwachungssignals auf. Ein zweiter Steuerkanal weist eine zweite Steuereinrichtung auf.

Das Überwachungssignal dient vor allem dazu, der Sicherheitsvorrichtung, insbesondere der zweiten Steuereinrichtung zu ermöglichen, die ordnungsgemäße Funktion der ersten, mikroprozessorgesteuerten Steuereinrichtung zu überwachen.

Mit der ersten, mikroprozessorgesteuerten Einrichtung und der zweiten Steuereinrichtung ist eine Eingangsstufe verbunden, die zum Modulieren eines Eingangssignals mit dem von der ersten mikroprozessorgesteuerten Steuereinrichtung kommenden Überwachungssignal ausgebildet ist. Die erste, mikroprozessorgesteuerte Steuereinrichtung und/oder die zweite Steuereinrichtung steuern unter Ansprechen auf das modulierte Eingangssignal die sicherheitstechnische Einrichtung bei Auftritt eines Fehlers in einen vorbestimmten sicheren Zustand.

### Vorteilhafte Weiterbildungen werden nachfolgend umschrieben.

Die erste, mikroprozessorgesteuerte Steuereinrichtung führt vorzugsweise sicherheitsrelevante Programme oder Programmteile durch, um das modulierte Eingangssignal beispielsweise unter sicherheitstechnischen Gesichtspunkten zu verarbeiten. So kann das modulierte Eingangssignal zum Beispiel in definierter Weise codiert werden.

Die Signalerzeugungseinrichtung ist derart ausgebildet, dass sie in Abhängigkeit von der Abarbeitung wenigstens eines sicherheitsrelevanten Programms durch die erste, mikroprozessorgesteuerte Steuereinrichtung das Überwachungssignal erzeugt. An dieser Stelle sei angemerkt, dass die Signalerzeugungseinrichtung vorzugsweise Bestandteil eines Mikroprozessors der ersten, mikroprozessorgesteuerten Steuereinrichtung ist.

Die erste, mikroprozessorgesteuerte Steuereinrichtung und die zweite Steuereinrichtung sind mit einer Ausgangsstufe verbunden. Die Steuereinrichtungen weisen jeweils eine Einrichtung zum Aktivieren oder Deaktivieren der Ausgangsstufe auf. Insbesondere enthält die Ausgangsstufe wenigstens eine Schalteinrichtung, die ein Relais sein kann. Allerdings kann die Ausgangsstufe auch mehrere Schalteinrichtungen aufweisen, die ein stufenweises oder sanftes Abschalten einer sicherheitstechnischen Einrichtung ermöglichen.

Die Aktivierungs-/Deaktivierungseinrichtung der ersten, mikroprozessorgesteuerten Steuereinrichtung weist einen mit Masse verbindbaren Schalter auf, während die zweite Steuereinrichtung einen mit einer Versorgungsspannung verbindbaren Schalter aufweist. Alternativ kann natürlich auch die erste Steuereinrichtung einen mit einer Versorgungsspannung verbindbaren Schalter und die zweite Steuereinrichtung einen mit Masse verbindbaren Schalter aufweisen. Auf diese Weise können die Steuereinrichtungen unabhängig voneinander die Ausgangsstufe absteuern, um die sicherheitstechnische Einrichtung in den gesicherten Zustand zu versetzen. Je nach schaltungstechnischer Implementierung der Ausgangsstufe befindet sich eine sicherheitstechnische Einrichtung nur im Betriebszustand, wenn der durch die erste Steuereinrichtung definierte Massepfad zur Ausgangsstufe geschlossen und über die zweite Steuereinrichtung die Vorsorgungsspannung an die Ausgangsstufe angelegt ist. Die sicherheitstechnische Einrichtung kann dann über die Ausgangsstufe in einen sicheren Zustand gefahren werden, wenn entweder der Massepfad geöffnet und/oder die Versorgungsspannung von der Ausgangsstufe getrennt wird.

Vorzugsweise ist die erste, mikroprozessorgesteuerte Steuereinrichtung zum Überwachen der Eingangsstufe und/oder der zweiten Steuereinrichtung ausgebildet.

Die Modulation des Eingangssignals mit dem Überwachungssignal der ersten, mikroprozessorgesteuerten Steuereinrichtung kann mittels einer logischen Verknüpfungseinrichtung, insbesondere einem UND-Gatter durchgeführt werden. Alternativ kann auch ein gewöhnlicher Schalter, auch ein mechanischer Schalter verwendet werden, um das Überwachungssignal beim Öffnen und Schließen des Schalters zu modulieren.

Um eine Fehlfunktion der ersten und/oder zweiten Steuereinrichtung infolge eines fehlerhaften, unkontrollierten Oszillierens des Überwachungssignals zu vermeiden, muss die erste, mikroprozessorgesteuerte Steuereinrichtung eine geeignete Signalform liefern. Hierzu weist die erste, mikroprozessorgesteuerte Steuereinrichtung einen Modulator zum Modulieren des Überwachungssignals mit einem Signal auf, dessen Frequenz höher als die Frequenz des Überwachungssignals ist. Das höherfrequente Signal kann das Taktsignal des die erste Steuereinrichtung steuernden Mikroprozessors sein. In diesem Fall ist die Eingangsstufe zum Modulieren des modulierten Überwachungssignals und des Eingangssignals ausgebildet. Die zweite Steuereinrichtung muss in diesem Fall in der Lage sein, die unterschiedlichen Spektralanteile im modulierten Eingangssignal erfassen und auswerten zu können. Hierzu weist die zweite Steuereinrichtung einen Demodulator auf, der unter Ansprechen auf das von der Eingangsstufe kommende modulierte Eingangssignal und das von der ersten, mikroprozessorgesteuerten Steuereinrichtung kommende modulierte Überwachungssignal bei Auftritt eines Fehlers ein Steuersignal erzeugt, welches die sicherheitstechnische Einrichtung in den vorbestimmten sicheren Zustand steuert.

Hierzu fungiert der Demodulator zweckmäßigerweise als Bandsperre. In Verbindung mit wenigstens einer Schalteinrichtung, insbesondere einem Monoflop, liefert der Demodulator, wenn sich die Frequenz des Signals mit höherer Frequenz um einen vorbestimmten Betrag ändert, ein Steuersignal zum Steuern der sicherheitstechnischen Einrichtung in den sicheren Zustand.

Vorzugsweise weist der Demodulator ein Hochpassfilter und ein erstes Tiefpassfilter auf, dessen jeweiliger Eingang mit dem Ausgang der ersten, mikroprozessorgesteuerten Einrichtung verbunden ist. Ein erstes Monoflop ist vorgesehen, welches einen Reset-Eingang und einen Signaleingang aufweist, der mit dem Ausgang des Hochpassfilters verbunden ist. Ein zweites Tiefpassfilter ist vorgesehen, dessen Eingang mit dem negierten Ausgang des ersten Monoflops verbunden ist. Ferner ist ein zweites Monoflop vorgesehen, dessen Signaleingang mit dem Ausgang des ersten Tiefpassfilters und dessen Reset-Eingang mit dem Ausgang des zweiten Tiefpassfilters verbunden ist. Weiterhin ist ein drittes Monoflop vorgesehen, dessen Signaleingang mit dem Ausgang der Eingangsstufe und dessen Reset-Eingang mit dem negierten Ausgang des zweiten Monoflops verbunden ist.

Vorzugsweise ist die erste, mikroprozessorgesteuerte Steuereinrichtung softwarebasiert und die zweite Steuereinrichtung hardwarebasiert, d. h. schaltungstechnisch realisiert. Ferner kann auch die zweite Steuereinrichtung durch einen Mikroprozessor gesteuert werden.

Bei dem Eingangssignal kann es sich um ein binäres Prozesssignal handeln, welches zum Anfahren und gesicherten Abschalten einer sicherheitstechnischen Einrichtung dient.

Die Erfindung wird nachfolgend anhand mehrerer Ausführungsbeispiele in Verbindung mit den beiliegenden Zeichnungen näher erläutert. In den Zeichnungen werden für gleiche Bauteile oder Komponenten die gleichen Bezugszeichen verwendet. Es zeigen:
- Fig. 1: ein Sicherheitsschaltgerät,
- Fig. 2: ein vereinfachtes Blockschaltbild einer zweikanaligen symmetrischen Sicherheitsvorrichtung gemäß dem Stand der Technik,
- Fig. 3: ein vereinfachtes Blockschaltbild einer Sicherheitsvorrichtung zum mehrkanaligen Steuern einer sicherheitstechnischen Einrichtung gemäß einer ersten erfindungsgemäßen Ausführungsform,
- Fig. 4: den zeitlichen Verlauf des Überwachungssignals, welches die erste, mikroprozessorgesteuerte Steuereinrichtung der in Fig. 3 gezeigten Sicherheitsvorrichtung erzeugt,
- Fig. 5: den prinzipiellen Schaltungsaufbau der in Fig. 3 gezeigten zweiten Steuereinrichtung,
- Fig. 6: eine alternative Sicherheitsvorrichtung zum mehrkanaligen Steuern einer sicherheitstechnischen Einrichtung gemäß der Erfindung,
- Fig. 7: den prinzipiellen Schaltungsaufbau der in Fig. 6 gezeigten zweiten Steuereinrichtung,
- Fig. 8a bis Fig. 8i: verschiedene Signalverläufe innerhalb der in Fig. 7 gezeigten Schaltungsanordnung an vorbestimmten Punkten während eines fehlerfreien Betriebs,
- Fig. 9a bis Fig. 9i: verschiedene Signalverläufe innerhalb der in Fig. 7 gezeigten Schaltungsanordnung an vorbestimmten Punkten während eines fehlerhaften Betriebs, und
- Fig. 10a bis Fig. 10i: verschiedene Signalverläufe innerhalb der in Fig. 7 gezeigten Schaltungsanordnung an vorbestimmten Punkten während eines fehlerhaften Betriebs.

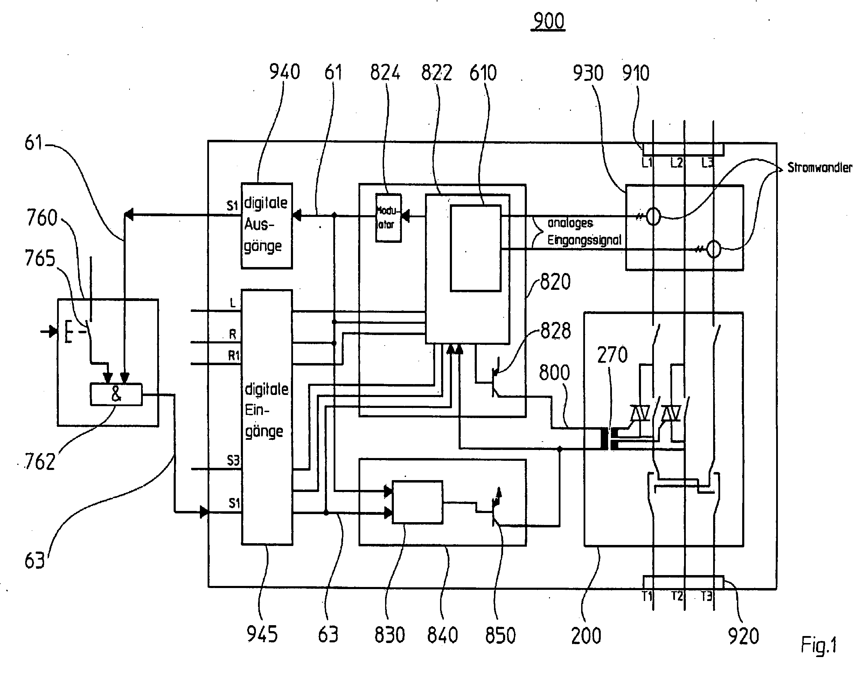

In Fig. 1 ist das Blockschaltbild eines beispielhaften Sicherheitsschaltgerät 900 dargestellt, dessen Komponenten in einem Gehäuse untergebracht sein können. Das Sicherheitsschaltgerät 900 weist eine erste Anschlusseinrichtung 910 auf, über die das Sicherheitsschaltgerät 900 beispielsweise an ein dreiphasiges Energieversorgungsnetz (nicht dargestellt) angeschaltet werden kann. Die drei mit dem Energieversorgungsnetz verbundenen Eingangsleiter sind in Fig. 1 mit L1, L2 und L3 bezeichnet. Die drei Leiter L1, L2 und L3 sind mit einer Leistungsendstufe 200 verbunden, deren drei ausgangsseitigen Leiter T1, T2 und T3 bezeichnet sind. Die drei ausgangseitigen Leiter sind mit einer zweiten Anschlusseinrichtung 920 verbunden, an die eine sicherheitstechnische Einrichtung, beispielsweise ein Drehstrommotor angeschlossen werden kann. Denkbar ist es, dass an das Sicherheitsschaltgerät 900 auch mehrere sicherheitstechnische Einrichtungen, wie z. B. ein- oder weitere mehrphasige Antriebe angeschlossen werden können. Dementsprechend ist die verwendete Leistungsendstufe ein- oder mehrphasig ausgebildet. Die Leistungsendstufe 200 ist der einfachen Darstellung wegen nur schematisch dargestellt.

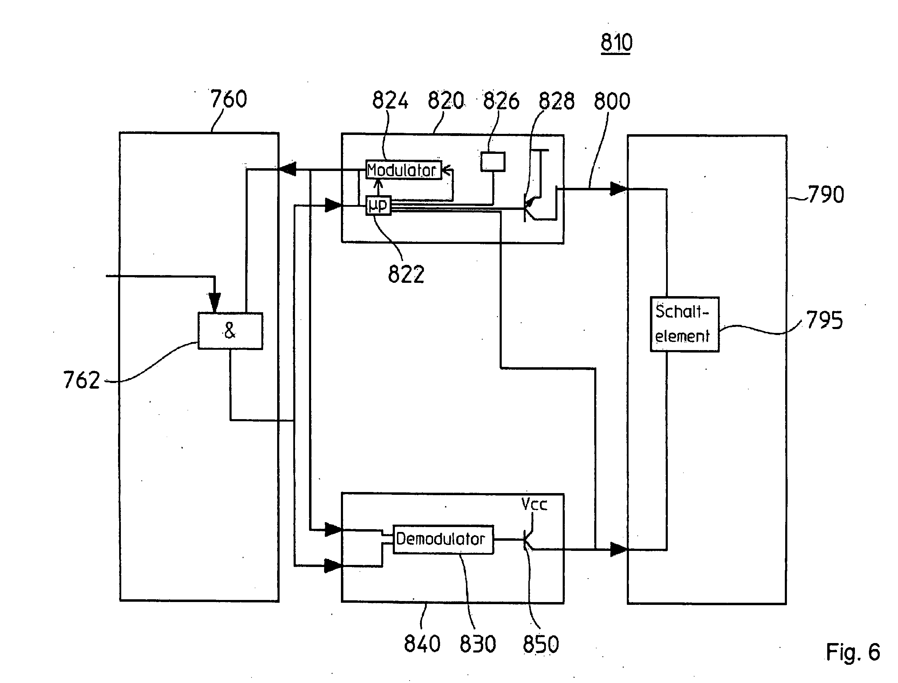

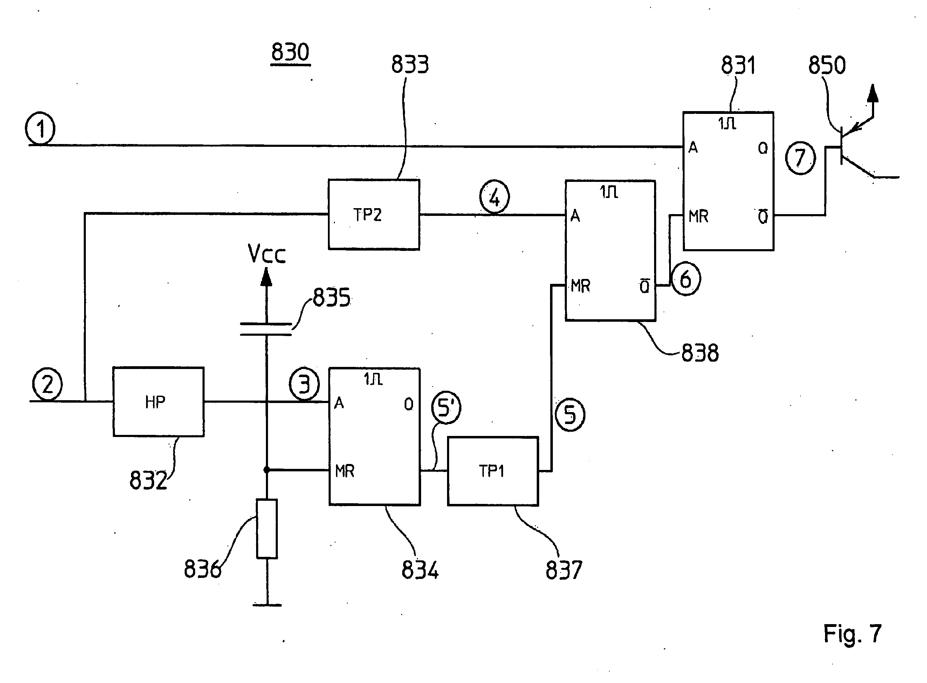

In die Eingangsleiter L1, L2 und L3 ist eine Einrichtung 930 mit Stromwandlern in den Leitern L1 und L3 geschaltet, die den analogen Strom in den Leitern L1 und L3 einer Messeinrichtung 610 zuführen. Die Messeinrichtung 610 kann Bestandteil einer programmierbaren Steuereinheit, zum Beispiel eines Mikrokontrollers oder Mikroprozessors 822 einer Steuereinrichtung 820 sein. Sie kann jedoch auch als separates Funktionsmodul ausgebildet sein. Hauptaufgabe der Messeinrichtung ist darin zu sehen, festzustellen, ob die Amplitude der Ströme in den Leitern L1 und L3 außerhalb eines vorbestimmten Arbeitsbereichs liegen. Wenn dies der Fall ist, steuert der Mikroprozessor 822 über einen Schalttransistor 828 die Leistungsendstufe 200 ab, um den angeschalteten Drehstrommotor von dem nicht dargestellten Energieversorgungsnetz zu trennen. Wie in der Fig. 1 schematisch dargestellt, ist der Schalttransistor 828 mit einem Übertrager 270 der Leistungsendstufe 200 verbunden. Die Mikroprozessor gesteuerte Steuereinrichtung 820 wird später anhand der Fig. 6 und 7 detaillierter beschrieben. Alternativ oder zusätzlich ist es möglich, in die Leiter L1 und L3 Spannungswandler einzuschleifen, die Leiterspannungen der Messeinrichtung 610 zuführen. Die Messeinrichtung 610 kann derart.ausgebildet sein, dass sie aus den empfangenen Spannungssignalen durch die Multiplikation mit den zugehörigen Stromsignalen die Wirkleistung ermittelt und prüft, ob die Wirkleistungen innerhalb oder außerhalb eines vorbestimmten Arbeitsbereichs liegen. Die tatsächlichen Werte des Arbeitsbereiches und die Zeitdauer, wie lange die Stromamplituden außerhalb des vorbestimmten Arbeitsbereiches liegen dürfen, ohne dass eine Abschaltung des Drehstrommotors erfolgt, können von einer Bedienperson eingestellt werden.

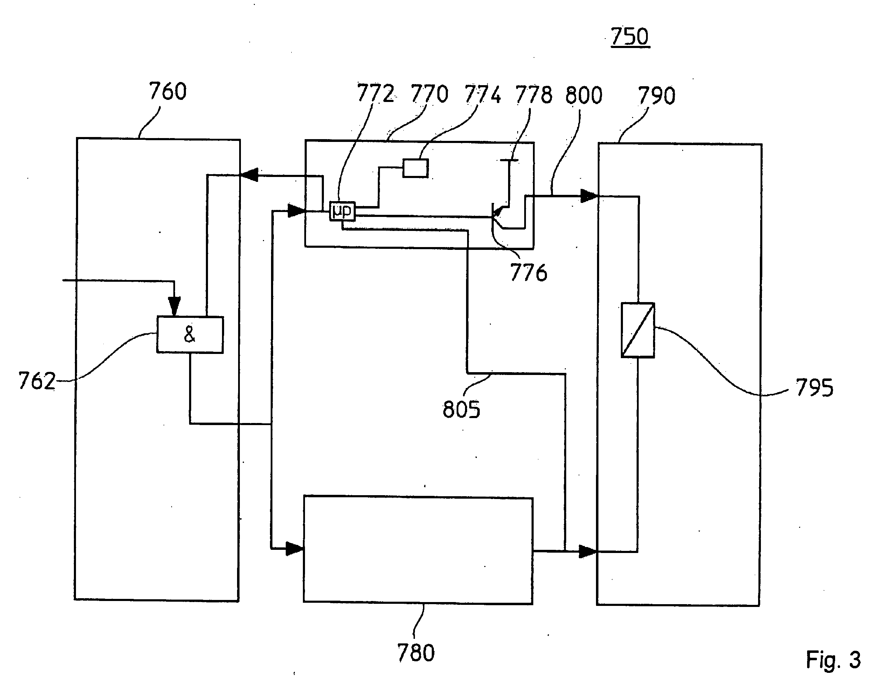

Weiterhin umfasst das Sicherheitsschaltgerät 900 eine weitere Steuereinrichtung 840 die einen Demodulator 840 und einen Schalttransistor 850 aufweist, der mit einem anderen Ende des Übertragers 270 der Leistungsendstufe 200 verbunden ist. Sowohl die Mikroprozessor gesteuerte Steuereinrichtung 820 als auch die Steuereinrichtung 840 sind Bestandteile einer mehrkanaligen Sicherheitsvorrichtung 810, die weiter unten anhand der Fig. 6 und 7 näher erläutert wird. Angemerkt sei an dieser Stelle, dass anstelle der Steuereinrichtungen 820 und 840 auch die Steuereinrichtungen 770 und 780 der in Fig. 3 dargestellten Sicherheitsvorrichtung 750 verwendet werden können. In diesem Zusammenhang sei noch darauf hin gewiesen, dass die in den Fig. 3 und 6 dargestellte Ausgangsstufe 790 zum Beispiel der in dem Sicherheitsschaltgerät eingesetzten Leistungsendstufe 200 entspricht.

Dem Mikroprozessor 822 der ersten Mikroprozessor gesteuerten Steuereinrichtung 820 ist ein Modulator 824 zugeordnet, dessen Ausgangssignal über einen digitalen Ausgang einer Schnittstelle 940 einer extern an das Sicherheitsschaltgerät 900 angeschlossenen Eingangsstufe 760 zugeführt wird. Man beachte, dass es sich bei dieser Eingangsstufe um die in den Fig. 3 und 6 dargestellte Eingangsstufe 760 der Sicherheitsvorrichtung 750 bzw. 810 handeln kann. Das Ausgangssignal der zweiten Steuereinrichtung 840 wird ebenfalls dem Mikroprozessor 822 zugeführt, der unter Ansprechen auf das empfangene Ausgangssignal die ordnungsgemäße Funktionsweise der zweiten Steuereinrichtung 840 überprüfen kann. Der Mikroprozessor 822 erzeugt in Verbindung mit dem Modulator 824 ein Überwachungssignal, welches signalisiert, ob die beiden Steuereinrichtungen 820 und 840 ordnungsgemäß arbeiten. Um sicherstellen zu können, dass der an das Sicherheitsschaltgerät 900 angeschaltete Drehstrommotor in einen sicheren Zustand gefahren werden kann, wenn entweder Schaltungskomponenten des Sicherheitsschaltgerätes 900, insbesondere die Steuereinrichtungen 820 und 840, defekt sind, oder von extern beispielsweise ein in der Eingangsstufe 760 implementierter Notausschalter 765 betätigt wird, wird sowohl das Eingangssignal des Notauschalters 765 als auch das Ausgangssignal des Modulators 824 einer Verknüpfungseinrichtung 762, welche beispielsweise ein Und-Gatter sein kann, zugeführt. Das Ausgangssignal der Verknüpfungseinrichtung 762 der Eingangsstufe 760 wird über eine Verbindung 63 einem digitalen Eingang einer Schnittstelle 945 des Sicherheitsschaltgerätes 900 zugeführt. Über die Schnittstelle 945 gelangt das Eingangssignal über einer Verbindung 63' zum Demodulator 830 der zweiten Steuereinrichtung 840 und zum Mikroprozessor 822. Erkennt der Demodulator 830 der Steuereinrichtung 840 oder der Mikroprozessor 822 der Steuereinrichtung 820, dass das vom Modulator 824 erzeugte Überwachungssignal einen Systemfehler signalisiert und/oder der Notausschalter 762 betätigt worden ist, so werden die jeweiligen Schalttransitoren 828 und 850 angesteuert, um die Leistungsendstufe 200 aufzutrennen, so dass die Energieversorgung über die Leiter L1, L2 und L3 zu den Ausgangsleitern T1, T2 und T3 und somit zum angeschlossenen Drehstrommotor unterbrochen wird.

An dieser Stelle sei angeführt, dass die in Fig. 1 gezeigte Eingangsstufe 760 lediglich der einfachen Darstellung wegen nur einen Schalter 765 enthält, der einen Notausschalter symbolisiert. Denkbar ist auch, einen Notausschalter mit mehreren Schaltern zu verwenden, wobei die Schalter in diesem Fall jeweils mit einem separaten Ausgang der Schnittstelle 940 und einem separaten Eingang der Schnittstelle 945 verbunden sein können. Ferner ist denkbar, dass die Eingangsstufe 760 alternativ oder zusätzlich zu einem Notausschalters, eine Schutztür, und/oder einen Zweihand-Schalter aufweisen kann. Je nach Ausführungsform werden die jeweiligen Ausgangssignale mit dem Überwachungssignal des Modulators 824 der Mikroprozessor gesteuerten Steuereinrichtung 828 in der Verknüpfungseinrichtung 762 verknüpft, wie dies nachfolgend noch näher erläutert wird.

Dank dieser besonderen Maßnahmen ist das Sicherheitsschaltgerät 900 in der Lage, eine komplexe und vielfältige sicherheitstechnische Überwachung einer an das Sicherheitsschaltgerät 900 angeschalteten sicherheitstechnischen Einrichtung, beispielsweise eines Drehstrommotors zu übernehmen. In einer besonders zweckmäßigen Ausführungsform sind die Anschlußeinrichtungen 910 und 920, die Leistungsendstufe 200, die Bauteile der Steuereinrichtung 820 und 850 sowie die Schnittstellen 940 und 945 auf einer Leiterplatte (nicht dargestellt angeordnet. Demzufolge muß bei der Implementierung einer Anlage mit sicherheitstechnischen Einrichtungen lediglich dafür gesorgt werden, dass die sicherheitstechnische Einrichtung mit dem Sicherheitsschaltgerät 900 verbunden wird. Die Bedienperson muß sich nicht darum kümmern, wie die sicherheitstechnische Einrichtung an die jeweiligen Motorschutzschalter und Schutzrelais und ggfs. an einen Notauschalter angeschlossen werden muß. Die Gefahr von Fehlverdrahtungen ist somit deutlich gegenüber den bekannten Maßnahmen reduziert.

Weiterhin kann die Schnittstelle 945 zwei digitale Eingänge aufweisen, an die zwei Leitungen R und L angeschlossen sind, über die Steuersignale für den Rechts- oder Linkslauf eines Drehstrommotors angelegt werden können. Die Steuersignale werden ebenfalls dem Mikroprozessor 822 zugeführt, der die Leistungsendstufe entsprechend ansteuert. Die einzelnen Verbindungsleitungen sind der besseren Übersichtlichkeit wegen nicht in der Figur 1 dargestellt. Weiterhin weist die Schnittstelle 945 einen weiteren Eingang R1 auf, an den ein nicht dargestellter Reset-Taster angeschlossen werden kann. Beispielsweise kann die Flanke eines angelegten Resetsignals vom Mikroprozessor 822 detektiert werden, der daraufhin die Leistungsendstufe 200 ansteuert, um nach Abschaltung des Drehstrommotors infolge eines Fehlers den Drehstrommotor wieder in Betrieb zu nehmen.

### Sicherheitsvorrichtung

Fig. 2 zeigt schematisch den Aufbau eines bekannten Systems zur mikroprozessorgesteuerten Überwachung einer sicherheitstechnischen Einrichtung (nicht dargestellt). Das System weist eine Eingangsstufe 710 auf, die ein binäres Prozess- oder Sensorsignal als Eingangssignal an zwei unabhängig voneinander arbeitende Subsysteme 720 und 730 anlegt. Jedes Subsystem kann einen Mikroprozessor und eine separate Stromversorgungseinrichtung aufweisen. Jedes Subsystem ist ausgangsseitig mit einer Ausgangsstufe 740 verbunden, die beispielsweise einen Schütz oder eine Anordnung aus Schalteinrichtungen aufweist. Mittels der Ausgangsstufe 740 kann eine nicht näher dargestellte sicherheitstechnische Anwendung in einen definierten gesicherten Zustand gefahren werden. Wie in Fig. 2 angedeutet, sind beide Subsysteme 720 und 730 derart ausgebildet, dass sie die Funktionsfähigkeit des jeweils anderen Subsystems überwachen können. Die gegenseitige Überwachung der Subsysteme erfolgt in der Regel durch einen bidirektionalen Austausch von Statusdaten, wie dies durch die Pfeile in Fig. 2 angedeutet ist. Jedes Subsystem bildet einen eigenen Steuerkanal, über den die Ausgangsstufe 740 separat angesteuert werden kann. Demzufolge kann jeder Kanal, das heißt jedes Subsystem die Ausgangsstufe 740 unabhängig von dem anderen Subsystem in einen als sicher definierten Zustand versetzen.

Die beispielhafte mehrkanalige Sicherheitsvorrichtung zur Steuerung von sicherheitstechnischen Einrichtungen ist in Fig. 3 dargestellt. Bereits an dieser Stelle sei darauf hingewiesen, dass unter sicherheitstechnischer Einrichtung eine Automatisierungsanlage, einzelne Baugruppen der Automatisierungsanlage und/oder auch sicherheitstechnische Anwendungen in Form von Software verstanden werden kann.

Ähnlich der in Fig. 2 gezeigten Anordnung weist die in Fig. 3 dargestellte Sicherheitsvorrichtung 750 eine Eingangsstufe 60, eine erste, mikroprozessorgesteuerte Steuereinrichtung 770 und eine zweite Steuereinrichtung 780 auf. Der Ausgang der beiden Steuereinrichtungen 770 und 780 ist jeweils mit einem Eingang einer Ausgangsstufe 790 verbunden. Die Ausgangsstufe 790 weist beispielsweise ein Relais 795 auf.

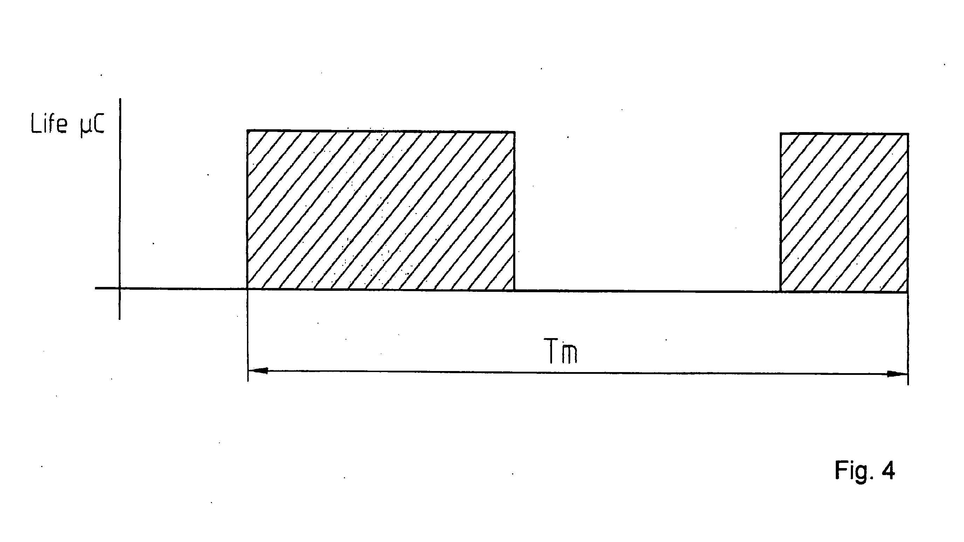

Von einer mehrkanaligen Steuervorrichtung 750 spricht man, da die erste, mikroprozessorgesteuerte Steuereinrichtung 770 und die zweite Steuereinrichtung 780 jeweils einen eigenen Steuerkanal zum unabhängigen Steuern des Relais 795 bilden. Die erste, mikroprozessorgesteuerte Steuereinrichtung 770 enthält einen speicherprogrammierten Mikroprozessor 772 und einen Speicher 774, in dem die Steuersoftware abgelegt ist, auf die der Mikroprozessor 772 zugreifen kann. Ferner enthält die mikroprozessorgesteuerte Steuereinrichtung 770 einen beispielsweise als NPN-Bipolartransistor ausgebildeten Schalter 776, nachfolgend auch Schalttransistor genannt, über den das Relais 795 mit einem Masseanschluss 778 verbunden werden kann. Über den Masseanschluss 778, den Schalttransistor 776 und eine Verbindungsleitung 800, die den Ausgang der mikroprozessorgesteuerten Steuereinrichtung 770 mit dem Eingang der Ausgangsstufe 790 und somit mit dem Eingang des Relais 795 verbindet, wird ein Massepfad definiert. Je nach Betriebszustand kann der Mikroprozessor 772 über den Schalttransistor 776 den Massepfad öffnen oder schließen. Der Mikroprozessor 772 ist derart ausgebildet, dass er ein Überwachungssignal, im nachfolgenden auch Life- Signal genannt, erzeugen kann, dessen zeitlicher Verlauf in Fig. 4 dargestellt ist.

Der Mikroprozessor 772 führt vorzugsweise mit dem von der Eingangsstufe gelieferten Signal sicherheitsrelevante Programme durch, damit bei Auftritt eines Fehlers die sicherheitstechnische Einrichtung über die Ausgangsstufe 790 zuverlässig in einen gesicherten Zustand gefahren werden kann. Als Fehlerquelle können zum Beispiel der Mikroprozessor 772 selbst, die Eingangsstufe 760 oder die sicherheitstechnische Einrichtung in Frage kommen. Das vom Mikroprozessor 772 erzeugte Überwachungssignal spiegelt den ordnungsgemäßen oder fehlerhaften Betrieb der mikroprozessorgesteuerten Steuereinrichtung 770 wieder.

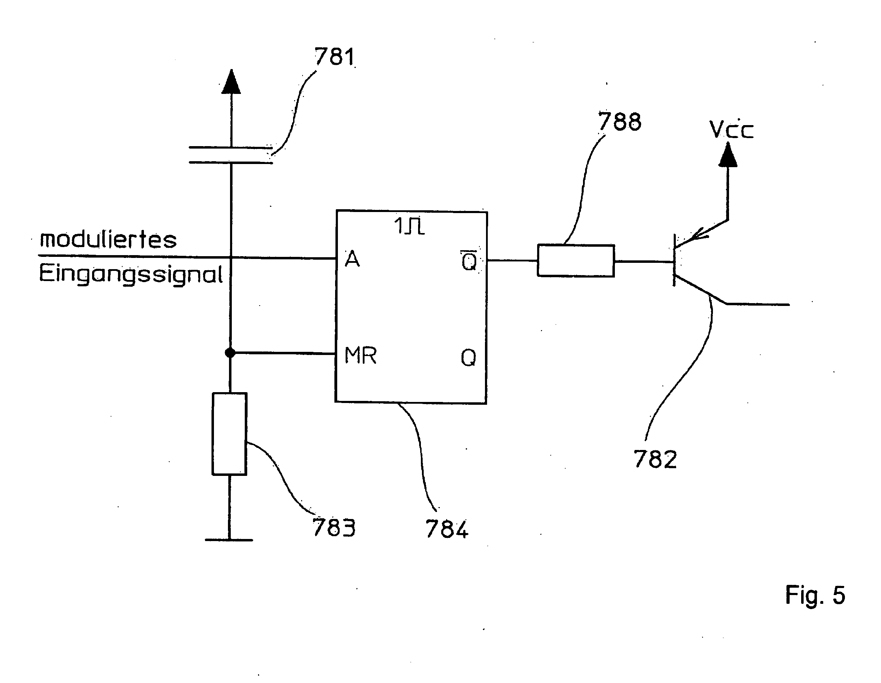

Das Überwachungssignal wird beispielsweise dadurch erzeugt, dass der Mikroprozessor 772 einen High-Pegel erzeugt, wenn der Mikroprozessor mit der Durchführung eines sicherheitsrelevanten Programmes beginnt. Sobald der Mikroprozessor 772 die Ausführung des sicherheitsrelevanten Programms beendet, erzeugt er einen Low- Pegel. In Fig. 4 ist der Verlauf des Überwachungssignals im fehlerfreien Zustand der Steuereinrichtung 770 dargestellt. Die in Fig. 4 eingezeichnete Periodendauer Tₘ entspricht beispielsweise der Zeitdauer einer in der Steuereinrichtung 780 implementierten monostabilen Kippstufe, nach deren Ablauf die Kippstufe wieder in ihren stabilen Zustand kippt. Eine solche monostabile Kippstufe ist als Monoflop 784 in Fig. 5 dargestellt. Die Zeitdauer Tₘ wird nachfolgend auch als Monozeit bezeichnet. Die Funktionsweise der Steuereinrichtung 800 wird weiter unten noch näher erläutert.

Das vom Mikroprozessor 772 erzeugte Life-Signal wird über einen Ausgang der mikroprozessorgesteuerten Steuereinrichtung 770 an einen Eingang der Eingangsstufe 760 angelegt. An einem weiteren Eingang der Eingangsstufe 760 liegt das binäre Prozesssignal an. Das Prozess signal und das Life-Signal werden beispielsweise eingangsseitig einem UND-Gatter 762 zugeführt. Das UND-Gatter 762 verknüpft oder moduliert beide Signale und liefert an seinem Ausgang ein sogenanntes moduliertes Eingangssignal für die Steuereinrichtungen 770 und 780. Alternativ kann an Stelle eines logischen UND-Gatters jede andere geeignete logische Verknüpfungseinrichtung oder ein mechanischer Schalter als Modulationseinrichtung verwendet werden. Entscheidend ist, dass bei der in Fig. 3 dargestellten Sicherheitsvorrichtung 750 das mit dem Überwachungssignal modulierte Prozesssignal und nicht das über die Eingangsstufe 760 kommende Prozesssignal unmittelbar an den Eingang der mikroprozessorgesteuerten Steuereinrichtung 770 und der Steuereinrichtung 780 angelegt wird.

Weiterhin ist zu beachten, dass die Steuereinrichtung 780 unabhängig von der mikroprozessorgesteuerten Steuereinrichtung 770 die Ausgangsstufe 790 ansteuern kann. Hierzu ist beispielsweise eine Versorgungsspannung V_{cc} vorgesehen, die über einen als Schalter fungierenden Transistor 782 an das Relais 795 der Ausgangsstufe 790 angelegt werden kann. An dieser Stelle sei bereits angemerkt, dass bei leitendem Zustand der Schalttransistoren 778 und 782 ein Strom durch das Relais 785 fließt.

Wie in Fig. 5 gezeigt, weist die Steuereinrichtung 780 neben dem Schalttransistor 782 das Monoflop 784 auf, welches einen mit *Q̅* bezeichneten negativen Ausgang aufweist, der vorzugsweise über einen Widerstand 788 mit der Steuerelektrode des Schalttransistors 782 verbunden ist. Ferner weist das Monoflop 784 einen Eingang A auf, an den das von der Eingangsstufe 760 kommende modulierte Eingangssignal angelegt wird. Weiter ist eine Reihenschaltung aus einem Kondensator 781 und einem Widerstand 783 vorgesehen, über die im Einschaltzeitpunkt der Sicherheitsvorrichtung 750 ein vorbestimmtes Spannungspotential an einen mit MR gekennzeichneten Master-Reset-Eingang angelegt wird, das bewirkt, dass das Monoflop am Q-Ausgang einen High-Pegel erzeugt.

Damit die als Master fungierende mikroprozessorgesteuerte Steuereinrichtung 770 Fehler in der Eingangsstufe 760 und in der Steuereinrichtung 780 erkennen kann, sind der Ausgang des UND-Gatters 762 der Eingangsstufe 760 und der Ausgang der Steuereinrichtung 780 jeweils mit einem Eingang der mikroprozessorgesteuerten Steuereinrichtung 770 verbunden. Da die'Eingangsgrößen und die Übertragungsfunktion der Steuereinrichtung 780 der mikroprozessorgesteuerten Steuereinrichtung 770 bekannt sind, kann ein ordnungsgemäßer Betrieb der Eingangsstufe 760 und der Steuereinrichtung 780 durch die rückgekoppelten Ausgangssignale verifiziert werden. Die Referenz-Parameter der Eingangsgrößen und der Übertragungsfunktion der Steuereinrichtung 80 können im Speicher 774 der Steuereinrichtung 770 abgelegt werden. Sollte ein Fehler auftreten, so kann sowohl die Steuereinrichtung 780 als auch die mikroprozessorgesteuerte Steuereinrichtung 770 die Ausgangsstufe 90 in einen sicheren Zustand überführen, indem entweder der über den Schalttransistor 776 und die Verbindungsleitung 100 gebildete Massepfad geöffnet und/oder die Versorgungsspannung mittels des Schalttransistors 82 der Steuereinrichtung 780 von dem Relais 795 der Ausgangsstufe 790 abgeschaltet wird.

Bei der Realisierung der in Fig. 3 dargestellten asymmetrischen, zweikanaligen Sicherheitsvorrichtung 750 ist ein kritischer Aspekt darin zu sehen, dass ein fehlerhaftes, unkontrolliertes Oszillieren des Life-Signals auftreten kann, welches ein sicheres Abschalten einer sicherheitstechnischen Einrichtung verhindern kann.

Eine Sicherheitsvorrichtung zur Lösung dieses Problems ist in Fig. 6 dargestellt. Die in dem in Fig. 1 dargestellten Sicherheitsschaltgerät 900 beispielhaft verwendete Sicherheitsvorrichtung 810 weist ähnlich der in Fig. 3 gezeigten Sicherheitsvorrichtung 750 eine Eingangsstufe 760 auf, die wiederum eine logische Verknüpfungseinrichtung, beispielsweise ein UND-Gatter 762 aufweisen kann. An einem Eingang des UND-Gatters 762 ist das Eingangssignal, welches das Prozesssignal sein kann, angelegt. Wiederum ist eine Ausgangsstufe 790 vorgesehen, die mehrere zusammenwirkende Schaltelemente 795 aufweisen kann, die ein definiertes Abschalten der sicherheitstechnischen Einrichtung ermöglicht. Die Sicherheitsvorrichtung 810 ist wiederum mehrkanalig, im vorliegenden Beispiel zweikanalig ausgebildet, wobei eine erste, mikroprozessorgesteuerte Steuereinrichtung 820 als Master und eine zweite Steuereinrichtung 840 als Slave fungiert. Wiederum kann die Steuereinrichtung 820 als softwarebasiertes Subsystem betrachtet werden, während die Steuereinrichtung 840 als hardwarebasiertes Subsystem ausgebildet sein kann, welches in Fig. 7 näher dargestellt ist.

Die mikroprozessorgesteuerte Steuereinrichtung 820 weist wiederum einen Mikroprozessor 822 auf, der ein niederfrequentes Überwachungs- oder Life-Signal erzeugen kann. Wiederum kann der Mikroprozessor 822 bei Beginn der Durchführung eines sicherheitsrelevanten Programms eine steigende Flanke und beim Verlassen der Ausführung des sicherheitsrelevanten Programms eine fallende Flanke erzeugen. Der zeitliche Abstand aufeinanderfolgender Impulse, das heißt die Periodizität des Überwachungssignals ist wiederum durch die Monozeit Tₘ eines Monoflops definiert. Im Unterschied zur Sicherheitsvorrichtung 750 gemäß Fig. 3 wird das vom Mikroprozessor 822 erzeugte Überwachungssignal einem Modulator 824 zugeführt, der das niederfrequente Überwachungssignal mit einem hochfrequenten Modulationssignal, welches beispielsweise das Taktsignal des Mikroprozessors 822, ein aus dem Taktsignal abgeleitetes Signal oder ein anderes hochfrequentes Signal sein kann, moduliert. In diesem Fall wird das Taktsignal des Mikroprozessors 822 an einen zweiten Eingang des Modulators 824 angelegt. Das vom Modulator 824 erzeugte modulierte Überwachungssignal wird einem weiteren Eingang des UND-Gatters 762 der Eingangsstufe und einem ersten Eingang der Steuereinrichtung 830 zugeführt. Am Ausgang des UND-Gatters 762 erscheint ein moduliertes Prozesssignal, welches durch das von der mikroprozessorgesteuerten Steuereinrichtung 820 gelieferte modulierte Überwachungssignal moduliert wird. Das modulierte Ausgangssignal des UND-Gatters 762 wird jeweils als ein moduliertes Eingangssignal an einen Eingang der mikroprozessorgesteuerten Steuereinrichtung 820 und an einen weiteren Eingang der Steuereinrichtung 840 angelegt. Der Mikroprozessor 822 ist wiederum in der Lage, das vom UND-Gatter 762 kommende Ausgangssignal hinsichtlich eines Fehlers zu überwachen. In einem Speicher 826 können Eingangsgrößen, die die Eingangsstufe 760 betreffen, sowie die Übertragungsfunktion der Steuereinrichtung 830 abgelegt sein. Der Mikroprozessor 722 ist mit der Steuerelektrode, im vorliegenden Beispiel mit der Basis eines Schalttransistors 828 verbunden, der über eine Verbindungsleitung 800 die Ausgangsstufe 790 mit Masse verbinden kann. Der Schalttransistor 828 kann beispielsweise als Bipolartransistor vom NPN-Typ ausgebildet sein. Beispielsweise ist die Emitterelektrode des Schalttransistors 828 mit Masse und die Elektroelektrode des Schalttransistors 828 mit dem Eingang der Ausgangsstufe 790 verbunden. Erkennt der Mikroprozessor 822 einen Fehler, so kann er den über den Schalttransistor 828 und die Verbindungsleitung 100 gebildeten Massepfad auftrennen, indem er einen Low-Pegel an die Steuerelektrode des Schalttransistors 828 anlegt, so dass der Schalttransistor sperrt.

Das Ausgangssignal der Steuereinrichtung 840 ist eingangsseitig mit der mikroprozessorgesteuerten Steuereinrichtung 820 verbunden. Der Mikroprozessor 822 ist wiederum derart implementiert, dass er unter Berücksichtigung der abgelegten Übertragungsfunktion der Steuereinrichtung 840 ein Fehlverhalten der Steuereinrichtung 830 erkennen kann. Die Steuereinrichtung 840 weist einen Demodulator 840 auf, der in Fig. 7 detaillierter dargestellt ist.

Der Ausgang des Demodulators 830 kann mit der Steuerelektrode eines Schalttransistors 850 verbunden sein, über den eine Versorgungsspannung an die Ausgangsstufe 790 angelegt werden kann. Der Demodulator 830 weist ein Monoflop 831 auf, welches in seiner Funktion dem Monoflop 784 der in Fig. 5 gezeigten Steuereinrichtung 780 entspricht. Das Monoflop 731 weist einen mit A gekennzeichneten Eingang auf, an den das vom UND-Gatter 762 kommende modulierte Eingangssignal angelegt wird. Das vom Modulator 824 gelieferte modulierte Überwachungssignal wird einem Hochpassfilter 832 und einem mit TP2 bezeichneten Tiefpassfilter 833 zugeführt. Das Ausgangssignal des Hochpassfilters 832 wird einem weiteren Monoflop 834 zugeführt. Das Monoflop 834 weist einen Master-Reset-Eingang auf, an dem eine Versorgungsspannung V_{cc} über eine Reihenschaltung, die einen Kondensator 835 und einen Widerstand 836 aufweist, angelegt werden kann. Der negierte Ausgang des Monoflops 834 wird an den Eingang eines weiteren, mit TP1 bezeichneten Tiefpassfilters 837 angelegt. Der Ausgang des Tiefpassfilters 833 ist mit einem ersten, mit A bezeichneten Eingang eines weiteren Monoflops 838 verbunden, während der Ausgang des Tiefpassfilters 837 mit dem Master-Reset-Eingang des Monoflops 838 verbunden ist. Der mit *Q̅* bezeichnete negative Ausgang des Monoflops 838 ist schließlich mit dem Master-Reset-Eingang des Monoflops 831 verbunden. Der mit *Q̅* bezeichnete negative Ausgang des Monoflops 831 ist mit der Steuerelektrode, im vorliegenden Beispiel mit der Basis des Schalttransistors 850 verbunden.

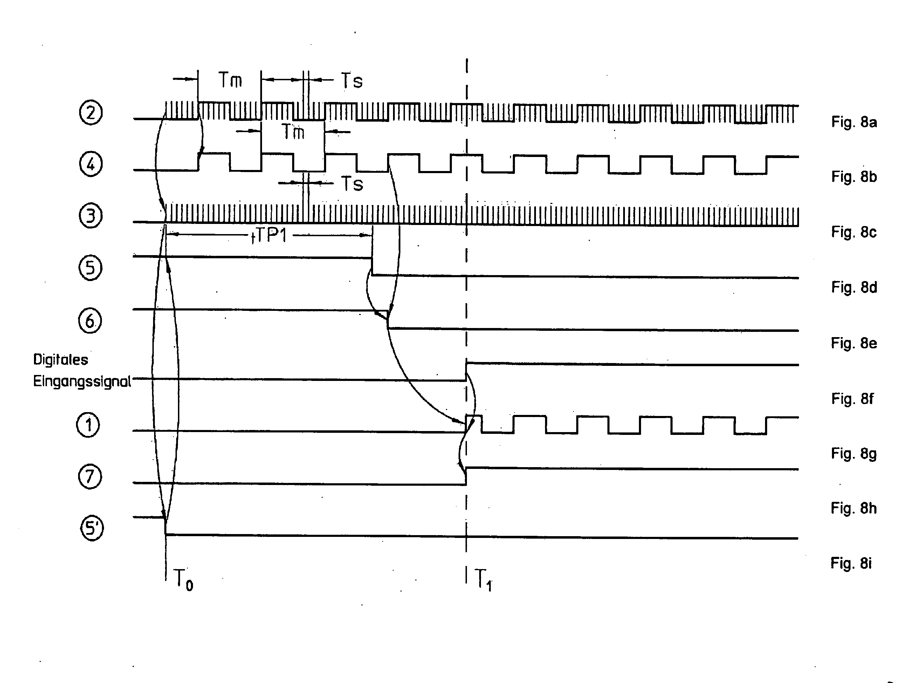

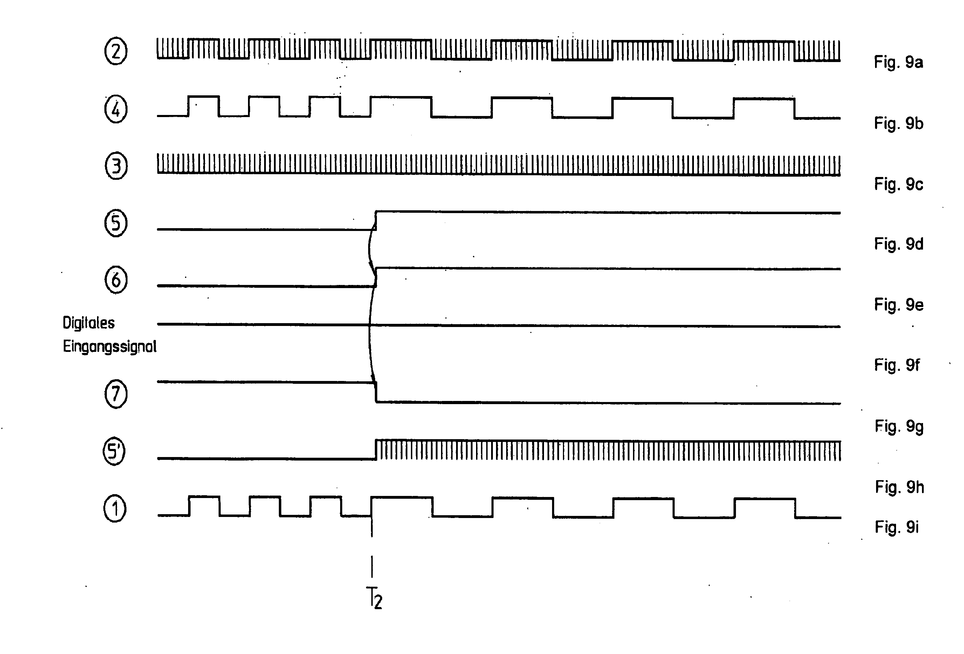

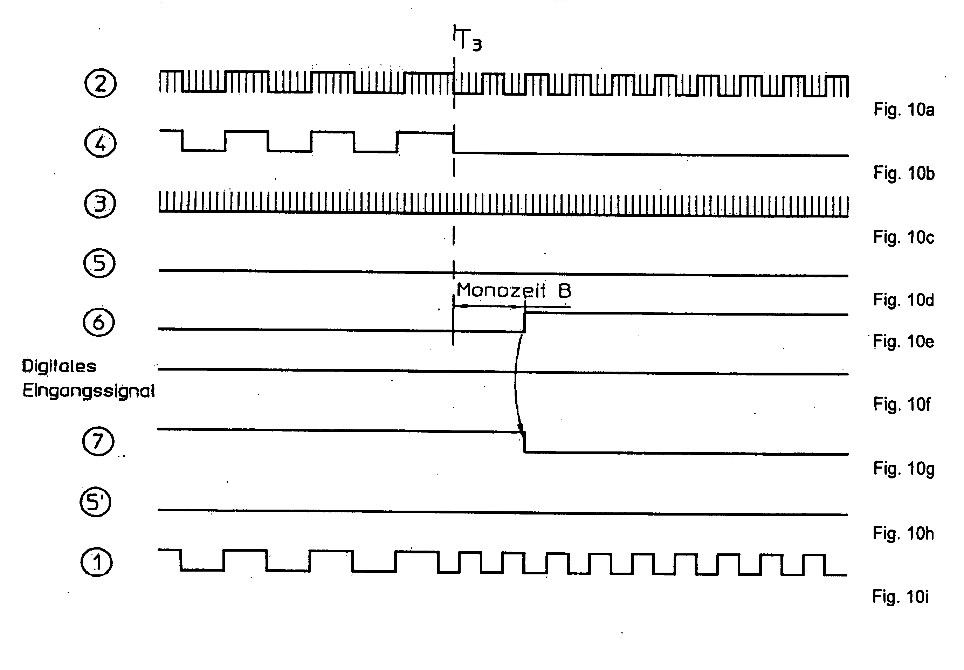

Die in den Fig. 8a bis 8i dargestellten Kurvenverläufe sind Eingangs- beziehungsweise Ausgangssignale an vorbestimmten Beobachtungspunkten innerhalb des Demodulators 830, welche mit den Nummern 1 bis 7 entsprechend gekennzeichnet sind. Die Spannungsverläufe treten bei einem ordnungsgemäßen Betrieb der Sicherheitsvorrichtung 810 auf. Bei einem fehlerhaften Betrieb der Steuereinrichtung 820 treten Spannungsverläufe auf, die in den Fig. 9a bis 9i bzw. 10a bis 10i gezeigt sind.

Nachfolgend wird die Funktionsweise der beiden in den Fig. 3 und 6 dargestellten Sicherheitsvorrichtungen 750 beziehungsweise 810 näher erläutert. Insbesondere wird die Funktionsweise der Steuereinrichtung 80 gemäß Fig. 3 und die Funktionsweise der in Fig. 6 gezeigten Steuereinrichtung 840 näher beschrieben.

Zunächst wird die Funktionsweise der in Fig. 3 gezeigten Steuereinrichtung 780 in Verbindung mit den Fig. 4 und 5 näher erläutert.

Es sei der Fall angenommen, dass eine sicherheitstechnische Automatisierungsanlage, zu der die Sicherheitsvorrichtung 750 gehört, in Betrieb genommen werden soll. Zu Beginn wird über den Kondensator 781 und den Widerstand 783 ein Spannungspotential an den Master-Reset-Eingang MR des Monoflops 784 angelegt, das bewirkt, dass der negative Ausgang *Q̅* des Monoflops 784 auf einen High-Pegel gesetzt wird, wodurch der Schalttransistor 782 in den sperrenden Zustand versetzt wird. Dies wiederum bewirkt, dass die Versorgungsspannung V_{cc} über den Schalttransistor 782 nicht an die Ausgangsstufe 790 angelegt wird. Hierdurch wird sichergestellt, dass die Ausgangsstufe 790 erst in Betrieb genommen werden kann, wenn eine Versorgungsspannung angelegt wird und die Durchführung von Selbsttests abgeschlossen ist.

Nach einer durch den Widerstandswert des Widerstandes und der Kapazität des Kondensators definierten Zeit nimmt das Spannungspotential am Master-Reset-Eingang des Monoflops 784 ab, so dass der Ausgang *Q̅* durch das am Eingang A anliegenden modulierten Eingangssignal, welches vom UND-Gatter 762 geliefert wird, abhängt. Angenommen sei, dass am UND-Gatter 762 der Eingangsstufe 760 ein Prozesssignal mit einem High-Pegel anliegt, so dass bei ordnungsgemäßer Funktion der Steuereinrichtung 70 das in Fig. 4 dargestellte Überwachungssignal als moduliertes Eingangssignal am Eingang A des Monoflops 784 anliegt. Mit der ersten positiven Flanke des modulierten Eingangssignals wird der Ausgang *Q̅* des Monoflops 784 für die Monozeit Tₘ auf Low gesetzt. Während dieser Zeit wird auch der Schalttransistor 782 leitend gehalten. Tritt, wie dies in Fig. 4 dargestellt ist, vor Ablauf der Monozeit Tₘ eine weitere positive Flanke im Überwachungssignal auf, wird das Monoflop 784 erneut getriggert und der Ausgang *Q̅* wird wiederum für die Monozeit Tₘ auf Low gesetzt. Solange der Mikroprozessor 772 der mikroprozessorgesteuerten Steuereinrichtung 770 ordnungsgemäß arbeitet, wird jeweils vor Ablauf der Monozeit Tₘ eine positive Flanke erzeugt. Solange die Automatisierungsanlage, die Steuereinrichtungen 770 und 780 sowie die Eingangsstufe 760 ordnungsgemäß arbeiten, wird der Schalttransistor 782 über das Monoflop 784 im leitenden Zustand gehalten. Ordnungsgemäßer Betrieb heißt, dass das Eingangssignal oder Prozesssignal am. Eingang des UND-Gatters 762 der Eingangsstufe 760 einen High-Pegel aufweiset und das modulierte Eingangssignal ein Wechselsignal ist, dessen Periodendauer kleiner oder gleich der Monozeit Tₘ ist.

Tritt nunmehr in der Steuereinrichtung 770 oder der Eingangsstufe 760 ein Fehler auf, sorgt das Monoflop 784 dafür, dass der Schalttransistor 782 in den sperrenden Zustand geschaltet und somit die Ausgangsstufe 790 von der Versorgungsspannung V_{cc} getrennt wird. Ein Fehler kann zum Beispiel auch dadurch signalisiert werden, dass ein Prozess signal mit einem Low-Pegel erzeugt wird, das dafür sorgt, dass der Ausgang des UND-Gatters 762 auf Null gesetzt wird. Demzufolge gelangt das Überwachungssignal nicht mehr an den Eingang A des Monoflops 782. Da am Eingang A des Monoflops innerhalb der Monozeit Tₘ keine positive Flanke mehr erscheint, wird der Ausgang Q des Monoflops 784 auf Null gesetzt. Dies führt dazu, dass der Schalttransistor 782 sperrt und somit die Versorgungsspannung von der Ausgangsstufe 790 getrennt wird. Die Automatisierungsanlage kann nunmehr in einen gesicherten Zustand gefahren werden.

Zudem kann ein Fehler in der Steuereinrichtung 770 auftreten, wenn beispielsweise der Mikroprozessor 772 aufgrund eines nicht vorhersehbaren Fehlers ein sicherheitsrelevantes Programm nicht startet. In diesem Fall bleibt das Überwachungssignal beispielsweise kontinuierlich auf einem Low-Pegel. Das wiederum dazu führt, dass über eine Zeitspanne, die Länger als die Monozeit Tₘ des Monoflops 784 ist, keine positive Flanke am Eingang A des Monoflops 784 auftritt, so dass der Schalttransistor 782 in den sperrenden Zustand versetzt wird. In ähnlicher Weise wird das Überwachungssignal auf einem High-Pegel verharren, wenn der Mikroprozessor 772 zwar ein sicherheitsrelevantes Programm gestartet hat, dieses aber aufgrund eines nicht vorhersehbaren Fehlers nicht mehr beenden kann. Auch dieser Zustand führt wiederum dazu, dass über eine Zeitspanne, die Länger als die Monozeit Tₘ des Monoflops 784 ist, keine positive Flanke am Eingang A des Monoflops 784 auftritt, so dass der Schalttransistor 782 in den sperrenden Zustand versetzt und die Ausgangsstufe 790 in einen gesicherten, vordefinierten Zustand gefahren wird. Angemerkt sei an dieser Stelle, dass je nach Realisierung der Steuereinrichtung 780 das Monoflop 784 auch durch fallende Flanken getriggert werden kann.

Dank der asymmetrischen, zweikanaligen Sicherheitsvorrichtung 750 ist es möglich, eine Automatisierungsanlage oder deren sicherheitstechnischen Komponenten bei Auftritt eines Fehlers, der seine Ursache zum Beispiel in der Eingangsstufe 760 oder der Sicherheitseinrichtung 770 hat, in einen sicheren Zustand zu gefahren.

Ein Fehler in der Steuereinrichtung 780 wird von der Steuereinrichtung 770 erkannt, indem das Ausgangssignal der Steuereinrichtung 780 über die Rückkopplungsleitung 805 zum Mikroprozessor 772 geführt wird. Denn die Steuereinrichtung 770 kennt die Übertragungsfunktion der Steuereinrichtung 780, die im Speicher 774 hinterlegt sein kann. Erkennt die Steuereinrichtung 770 einen Fehler im Ausgangssignal der Steuereinrichtung 780, sorgt der Mikroprozessor 772 dafür, dass der Schalttransistor 776 gesperrt und somit der Massepfad zur Ausgangsstufe 790 geöffnet wird.

Anzumerken sei noch, dass das Monoflop 784 ferner dazu dient, die Einschaltzeit des angelegten modulierten Eingangssignals um die Monozeit Tₘ zu verlängern, so dass auch nach dem Abschalten des Eingangssignals oder Prozesssignals die Ausgangsstufe 790 noch kontrolliert in einen gesicherten Zustand gesteuert werden kann. Um die Sicherheitsbedingungen, die zum gesicherten Abschalten einer Automatisierungsanlage erforderlich sind, einhalten zu können, darf die Monozeit Tₘ nicht länger als die Sicherheitsabschaltzeit der Ausgangsstufe 90 sein.

Nachfolgend wird die Funktionsweise der in Fig. 6 dargestellten asymmetrischen zweikanaligen Sicherheitsvorrichtung 810 in Verbindung mit den Fig. 7 bis 9i näher erläutert.

Der in Fig. 7 gezeigte Demodulator 130 der Steuereinrichtung 840 weist im Unterschied zu der in Fig. 5 gezeigten Schaltungsanordnung eine Tiefpass- und Hochpassanordnung auf, durch die quasi eine digitale Bandsperre realisiert wird. Bei korrekter Dimensionierung der Baukomponenten und ordnungsgemäßer Funktionsweise der Sicherheitsvorrichtung 810 verhält sich der Demodulator 830 ähnlich dem in Fig. 5 gezeigten Monoflop 784. Tritt jedoch in der Steuereinrichtung 820, beispielsweise im Mikroprozessor 822 ein Fehler auf, so wird je nach Fehlerfall der hochfrequente und niederfrequente Anteil des vom Modulator 824 kommenden modulierten Überwachungssignals zu höheren oder niedrigeren Frequenzen verschoben. Die Folge davon ist, dass entweder der hochfrequente oder niederfrequente Anteil des modulierten Überwachungssignals durch das Bandsperrverhalten des Demodulators 830 gesperrt wird. Dies führt dazu, dass das Monoflop 831 nach Ablauf der Monozeit den positiven Ausgang Q auf Low setzt, wodurch der Schalttransistor 850 in den sperrenden Zustand versetzt und somit die Ausgangsstufe 790 in einen sicheren Zustand gefahren wird. Angemerkt sei noch, dass die Steuereinrichtung 720 ein Softwaremodul aufweist, welches dafür sorgt, dass eine Veränderung des Taktes des Mikroprozessors 720 zu einer entsprechenden Frequenzverschiebung des Life-Signals führt.

Die Funktionsweise des Demodulators 830 wird anhand der Fig. 8a bis 10i detailliert beschrieben. Zunächst wird der fehlerfreie Betrieb der Steuereinrichtung 820 geschildert.

Bei einem fehlerfreien Betrieb der Sicherheitsvorrichtung 810 treten an den in Fig. 7 eingezeichneten Beobachtungspunkten die in den Fig. 8a bis 8i gezeigten Signalverläufe auf.

Wir betrachten zunächst den Zeitraum von T₀ bis T₁. Angenommen sei, dass bis zum Zeitpunkt T₁ an das UND-Gatter 762 kein Prozess signal angelegt wird, wie dies in Fig. 8f gezeigt ist. Somit liegt bis zum Zeitpunkt T₁ am Eingang A des Monoflops 831 kein Signal an, wie dies in Fig. 8g gezeigt ist. Fig. 8a zeigt schematisch das modulierte Überwachungssignal, welches eine Überlagerung des Taktsignals des Mikroprozessors 822 und des in Fig. 4 gezeigten Überwachungssignals ist. In dem dargestellten Kurvenverlauf, der bereits zum Zeitpunkt T₀ beginnt, fällt die Periodendauer des Überwachungssignals etwa mit der Monozeit Tₘ des Monoflops 831 zusammen. Das vom Modulator 824 der Steuereeinrichtung 820 als Modulationssignal verwendete Taktsignal des Mikroprozessors 822 weist eine Periodendauer von Tₛ auf, die ebenfalls in Fig. 8a eingetragen ist. An dieser Stelle sei noch erwähnt, dass die Kapazität 835 und den Widerstand 836 aufweisende Reihenschaltung dazu dient, im Einschaltzeitpunkt der Automatisierungsanlage ein Spannungspotential an den Master-Reset-Eingang des Monoflops 834 anzulegen, der zum Zeitpunkt T₀ für einen Low-Pegei am negierten Ausgang *Q̅* des Monoflops 834 sorgt, wie dies in Fig. 8i gezeigt ist.

Fig. 8b zeigt den niederfrequenten Anteil des modulierten Überwachungssignal, welcher am Ausgang des Tiefpassfilters 833 anliegt. Fig. 8c zeigt den hochfrequenten Anteil des modulierten Überwachungssignals, welcher am Ausgang des Hochpassfilters 832 anliegt. Fig. 8i zeigt den am negierte Ausgang *Q̅* des Monoflops 834 anliegenden Signalverlauf, der zum Zeitpunkt T₀, wenn das modulierte Eingangssignal gemäß Fig. 8a an das Hochpassfilter 832 angelegt wird, auf Null geht, da positive Flanken des in Fig. 8c gezeigten hochfrequenten Signalanteils jeweils vor Ablauf der speziellen Monozeit des Monoflops 834 dieses triggern. Fig. 8d zeigt den am Ausgang des Tiefpassfilters 837 anliegenden Signalverlauf, der nach einer vorbestimmten Laufzeit den Wert des Signalverlaufs nach Fig. 8i, d. h. den Wert Null annimmt. Fig. 8e zeigt den am negierten Ausgang *Q̅* des Monoflops 838 anliegenden Signalverlauf. Fig. 8h zeigt den Signalverlauf am Ausgang Q des Monoflops 831.

Zum Zeitpunkt T₁ werde nunmehr ein Prozess signal, welches auch ein Sensorsignal sein kann, mit einem High-Pegel an das UND-Gatter 762 angelegt, wie in Fig. 8f gezeigt. Von diesem Zeitpunkt an liefert das UND-Gatter 762 das in Fig. 8g gezeigte Wechselsignal. Dieses Signal enthält im vorliegenden Beispiel aufgrund systembedingter Tiefpasseigenschaften keine Hochfrequenzanteile mehr. Vielmehr entspricht es dem Überwachungssignal mit einer Periodendauer von kleiner oder gleich Tₘ.

Da im ordnungsgemäßen Betrieb am negierten Ausgang *Q̅* des Monoflops 838 ein Low-Pegel gemäß Fig. 8e anliegt, der gleichzeitig am Master-Reset-Eingang des Monoflops 831 anliegt, wird dessen Verhalten vom modulierten Eingangssignal nach Fig. 8g bestimmt. Da die Periodendauer des modulierten Eingangssignals, wie gesagt, kleiner der Monozeit Tₘ des Monoflops 831 ist, wird das Monoflop 831 regelmäßig getriggert. Demzufolge liefert der Ausgang Q des Monoflops 831 einen High-Pegel, wie in Fig. 8h dargestellt. Dies hat wiederum zur Folge, dass der Schalttransistor 850 im leitenden Zustand gehalten und die Ausgangsstufe mit Energie versorgt wird.

Nunmehr sei der Fehlerfall angenommen, dass die Frequenz des Taktes des Mikroprozessors 822 zum Zeitpunkt T₂ sinkt. Dies ist in Fig. 9a für das modulierte Überwachungssignal, welches am Eingang des Hochpassfilters 832 und am Eingang des Tiefpassfilters 833 angelegt wird, dargestellt. Wie ersichtlich ist, ist der zeitliche Abstand der Taktimpulse nach dem Zeitpunkt T₂ länger. Demzufolge zieht eine Verlängerung der Periodendauer des Taktsignals des Mikroprozessors 822 eine Verlängerung der Periodendauer des Überwachungssignals nach sich. Auch dieser Sachverhalt ist in Fig. 9a dargestellt. Fig. 9f zeigt, dass nach wie vor ein Prozesssignal mit High-Pegel am UND-Gatter 762 anliegt, welches normalen Betriebszustand der Anlage darstellt. Fig. 9b zeigt die Veränderung des Ausgangssignals am Tiefpassfilter 833 nach dem Zeitpunkt T₂, nachdem die Frequenz des Taktsignals des Mikroprozessors 822 gesunken ist.

Fig. 9c zeigt die Änderung des Taktsignals des Mikroprozessors 822 zum Zeitpunkt T₂. Da der zeitliche Abstand aufeinander folgender positiver Flanken im Taktsignal des Mikroprozessors 822 zum Zeitpunkt T₂ länger als die Monoflopzeit des Monoflop 834 ist, erscheint am negierten Ausgang *Q̅* des Monoflops 834 das in Fig. 9h dargestellte hochfrequente Taktsignal des Mikroprozessors 822. Das Tiefpassfilter 837 filtert die hochfrequenten Anteile aus dem Ausgangssignal am negierten Ausgang *Q̅* des Monoflops 834 heraus, so dass am Ausgang des Tiefpassfilters 837 nach Ablauf der Monozeit des Monoflops 834 ein High-Pegel anliegt, wie er in Fig. 9d dargestellt ist. Der High-Pegel wird an den Master-Reset-Eingang des Monoflops 838 angelegt und sorgt dafür, dass am negierten Ausgang des Monoflops 838 ein High-Pegel erzeugt wird, der in Fig. 9e dargestellt ist. Demzufolge wird über den Master-Reset-Eingang des Monoflops 831 ein Ausgangssignal mit Low-Pegel erzeugt, wie in Fig. 9g gezeigt. Dieses Signal steuert den Schalttransistor 850 in den gesperrten Zustand. Demzufolge wird die Versorgungsspannung von der Ausgangsstufe 790 abgetrennt, so dass die Ausgangsstufe 790 eine sicherheitstechnische Einrichtung in einen sicheren Zustand fahren kann.

Die Signalverläufe in den Fig. 10a bis 10i treten bei einem Fehler in der Steuereinrichtung 820 auf, der sich in einer Erhöhung der Taktfrequenz des Mikroprozessorsignals äußert. Fig. 10a zeigt das an dem Eingang des Hochpassfilters 832 und an dem Eingang des Tiefpassfilters 833 ankommende modulierte Überwachungssignal, welches sich zu einem Zeitpunkt T₃ wie dargestellt ändert. Immer noch sei angenommen, dass die Eingangsstufe 760 und die Automatisierungsanlage selbst fehlerfrei arbeiten, so dass am UND-Gatter 762 nach wie vor ein Prozesssignal mit einem High-Pegel anliegt, wie dies in Fig. 10f dargestellt ist. Fig. 10i zeigt die Veränderung des modulierten Eingangssignals nach dem Zeitpunkt T₃, welches an den Eingang A des Monoflops 831 angelegt wird. Fig. 10c zeigt wiederum die Veränderung des Taktsignals am Ausgang des Tiefpassfilters 832 zum Zeitpunkt T₃. Das in Fig. 10c gezeigte hochfrequente Eingangssignal bewirkt, dass am negierten Ausgang des Monoflops 834 dauerhaft ein Low-Pegel anliegt, der in Fig. 10h dargestellt ist. Der Low-Pegel wird über das Tiefpassfilter 837 an den Master-Reset-Eingang des Monoflops 838 angelegt. Das Tiefpassfilter 833 ist derart dimensioniert, dass es auch den niederfrequenten Anteil des fehlerbehafteten modulierten Überwachungssignals, welches in Fig. 10a dargestellt ist, ab dem Zeitpunkt T₃ sperrt, wie dies durch den Spannungsverlauf in Fig. 10b dargestellt ist. Da am Eingang A des Monoflops 838 nur noch ein konstanter Pegel anliegt, wird nach Ablauf der Monozeit des Monoflops 838 der negierte Ausgang auf einen High-Pegel gesetzt, wie dies durch Fig. 10e dargestellt ist. Über den Master-Reset-Eingang MR wird nunmehr das Monoflop 831 rückgesetzt, wodurch der Ausgang des Monoflops 831 auf Null gesetzt wird, wie dies in Fig. 10g dargestellt ist. Wiederum wird der Schalttransistor 850 gesperrt und somit die Spannungsversorgung von der Ausgangsstufe 790 getrennt.

## Patentansprüche

1. Sicherheitsvorrichtung zum mehrkanaligen Steuern einer sicherheitstechnischen Einrichtung, mit
einer ersten, mikroprozessorgesteuerten Steuereinrichtung (770; 820), die eine Signalerzeugungseinrichtung (772; 822) zum Erzeugen eines Überwachungssignals aufweist,
einer zweiten Steuereinrichtung (780; 840),
einer mit der ersten, mikroprozessorgesteuerten Einrichtung (770; 820) und der zweiten Steuereinrichtung (780; 840) verbundenen Eingangsstufe (760), die zum Modulieren eines Eingangssignals mit dem von der ersten,
mikroprozessorgesteuerten Steuereinrichtung (770; 820) kommenden Überwachungssignal ausgebildet ist, wobei die erste, mikroprozessorgesteuerte Steuereinrichtung (770; 820) und/oder die zweite Steuereinrichtung (780; 840) unter Ansprechen auf das modulierte Eingangssignal die sicherheitstechnische Einrichtung bei Auftritt eines Fehlers in einen vorbestimmten sicheren Zustand steuern.

2. Sicherheitsvorrichtung nach Anspruch 1,
**dadurch gekennzeichnet, dass**
die Signalerzeugungseinrichtung das Überwachungssignal in Abhängigkeit von der Abarbeitung wenigstens eines sicherheitsrelevanten Programms durch die erste, mikroprozessorgesteuerte Steuereinrichtung (770; 820) erzeugt.

3. Sicherheitsvorrichtung nach Anspruch 1 oder 2,
**dadurch gekennzeichnet, dass**
die erste, mikroprozessorgesteuerte Steuereinrichtung (770; 820) und die zweite Steuereinrichtung (780; 840) mit einer Ausgangsstufe (790) verbunden sind und jeweils eine Einrichtung zum Aktivieren oder Deaktivieren der Ausgangsstufe (790) aufweisen.

4. Sicherheitsvorrichtung nach Anspruch 3,
**dadurch gekennzeichnet, dass**
die Aktivierungs-/Deaktivierungseinrichtung der ersten, mikroprozessorgesteuerten Steuereinrichtung (770; 820) einen mit Masse verbindbaren Schalter (776; 828) und die Aktivierungs-/Deaktivierungseinrichtung der zweiten Steuereinrichtung (780; 840) einen mit einer Versorgungsspannurig verbindbaren Schalter (782; 850) aufweist.

5. Sicherheitsvorrichtung nach Anspruch 3 oder 4,
**dadurch gekennzeichnet, dass**
die Ausgangsstufe (790) wenigstens eine Schalteinrichtung (795), insbesondere ein Relais ist.

6. Sicherheitsvorrichtung nach einem der Ansprüche 1 bis 5,
**dadurch gekennzeichnet, dass**
die erste, mikroprozessorgesteuerte Steuereinrichtung (770; 820) eine Einrichtung zum Überwachen der Eingangsstufe und/oder der zweiten Steuereinrichtung und zum Erzeugen eines Fehlersignals aufweist, und dass
die erste, mikroprozessorgesteuerte Steuereinrichtung (770; 820) unter Ansprechen auf das Fehlersignal die sicherheitstechnische Einrichtung in einen vorbestimmten sicheren Zustand steuert.

7. Sicherheitsvorrichtung nach einem der Ansprüche 1 bis 6,
**dadurch gekennzeichnet, dass**
die Eingangsstufe (760) eine logische Verknüpfungseinrichtung (762), insbesondere ein UND-Gatter zum Modulieren des Eingangssignals mit dem Überwachungssignal aufweist.

8. Sicherheitsvorrichtung nach einem der Ansprüche 1 bis 7,
**dadurch gekennzeichnet, dass**
die erste, mikroprozessorgesteuerte Steuereinrichtung (820) einen Modulator (824) zum Modulieren des Überwachungssignals mit einem Signal aufweist, dessen Frequenz höher als die Frequenz des Überwachungssignals ist, dass
die Eingangsstufe (760) zum Modulieren des modulierten Überwachungssignals mit dem Eingangssignal ausgebildet ist, dass
die zweite Steuereinrichtung (840) einen Demodulator (830) aufweist, der unter Ansprechen auf das von der Eingangsstufe (760) kommende modulierte Eingangssignal und das von der ersten, mikroprozessorgesteuerten Steuereinrichtung (820) kommende modulierte Überwachungssignal bei Auftritt eines Fehlers ein Steuersignal erzeugt, welches die sicherheitstechnische Einrichtung in den vorbestimmten sicheren Zustand steuert.

9. Sicherheitsvorrichtung nach Anspruch 8,
**dadurch gekennzeichnet, dass**
der Demodulator (830) ein Bandsperre und wenigstens eine Schalteinrichtung (831), insbesondere ein Monoflop, aufweist, die bei Veränderung der Frequenz des Signals mit höherer Frequenz um einen vorbestimmten Betrag ein Steuersignal zum Steuern der sicherheitstechnischen Einrichtung in den vorbestimmten sicheren Zustand liefert.

10. Sicherheitsvorrichtung nach Anspruch 9,
**dadurch gekennzeichnet, dass**
der Demodulator (830) folgende Merkmale aufweist:
ein Hochpassfilter (832) und ein erstes Tiefpassfilter (833), dessen jeweiliger Eingang mit dem Ausgang der ersten, mikroprozessorgesteuerten Einrichtung (820) verbunden ist,
ein erstes Monoflop (834), welches einen Reset-Eingang und einen Signaleingang aufweist, der mit dem Ausgang des Hochpassfilters verbunden ist,
ein zweites Tiefpassfilter (837), dessen Eingang mit dem negierten Ausgang des ersten Monoflops (834) verbunden ist,
ein zweites Monoflop (838), dessen Signaleingang mit dem Ausgang des ersten Tiefpassfilters (833) und dessen Reset-Eingang mit dem Ausgang des zweiten Tiefpassfilters (837) verbunden ist, und
ein drittes Monoflop (831), dessen Signaleingang mit dem Ausgang der Eingangsstufe (760) und dessen Reset-Eingang mit dem negierten Ausgang des zweiten Monoflops (838) verbunden ist.

11. Sicherheitsvorrichtung nach einem der Ansprüche 1 bis 10,
**dadurch gekennzeichnet, dass**
die erste, mikroprozessorgesteuerte Steuereinrichtung (770; 820) Software basiert und die zweite Steuereinrichtung (780; 840) Hardwarebasiert ist.

12. Sicherheitsvorrichtung nach einem der Ansprüche 1 bis 11,
**dadurch gekennzeichnet, dass**
das Eingangssignal ein binäres Prozesssignal ist.

13. Sicherheitsvorrichtung nach einem der Ansprüche 1 bis 121, **dadurch gekennzeichnet, dass**
die zweite Steuereinrichtung (780; 840) einen Mikroprozessor aufweist.

## Claims

1. Safety apparatus for the multi-channel control of a safety-related device, having a first control device (770; 820) which is controlled by a microprocessor and comprises a signal-producing device (772; 822) for producing a monitoring signal,
a second control device (780; 840),
an input stage (760) which is connected to the first device (770; 820) controlled by a microprocessor and to the second control device (780; 840) and is designed to modulate an input signal with the monitoring signal emanating from the first control device (770; 820) controlled by a microprocessor, wherein the first control device (770; 820) controlled by a microprocessor and/or the second control device (780; 840) controls the safety-relevant device to a predetermined safe state in response to the modulated input signal upon the occurrence of an error.

2. Safety apparatus as claimed in Claim 1, **characterised in that**
the signal-producing device produces the monitoring signal in dependence upon the execution of at least one safety-relevant programme by the first control device (770; 820) controlled by a microprocessor.

3. Safety apparatus as claimed in Claim 1 or 2, **characterised in that**
the first control device (770; 820) controlled by a microprocessor and the second control device (780; 840) are connected to an output stage (790) and each comprise a device for activating or deactivating the output stage (790).

4. Safety apparatus as claimed in Claim 3, **characterised in that**
the activation/deactivation device of the first control device (770; 820) controlled by a microprocessor comprises a switch (776; 828) which can be connected to earth and the activation/deactivation device of the second control device (780; 840) comprises a switch (782; 850) which can be connected to a supply voltage.

5. Safety apparatus as claimed in Claim 3 or 4, **characterised in that**
the output stage (790) is at least one switching device (795), in particular a relay.

6. Safety apparatus as claimed in any one of Claims 1 to 5, **characterised in that** the first control device (770; 820) controlled by a microprocessor comprises a device for monitoring the input stage and/or the second control device and for producing an error signal, and **in that**
the first control device (770; 820) controlled by a microprocessor controls the safety-relevant device to a predetermined safe state in response to the error signal.

7. Safety apparatus as claimed in any one of Claims 1 to 6, **characterised in that** the input stage (760) comprises a logic function device (762), in particular an AND gate for modulating the input signal with the monitoring signal.

8. Safety apparatus as claimed in any one of Claims 1 to 7, **characterised in that**
the first control device (820) controlled by a microprocessor comprises a modulator (824) for modulating the monitoring signal with a signal whose frequency is higher than the frequency of the monitoring signal, **in that** the input stage (760) is designed to modulate the modulated monitoring signal with the input signal, **in that**
the second control device (840) comprises a demodulator (830) which, in response to the modulated input signal emanating from the input stage (760) and to the modulated monitoring signal emanating from the first control device (820) controlled by a microprocessor, produces a control signal upon the occurrence of an error, which control signal controls the safety-relevant device to the predetermined safe state.

9. Safety apparatus as claimed in Claim 8, **characterised in that**
the demodulator (830) comprises a band-stop filter and at least one switching device (831), in particular a monostable multivibrator, which switching device, upon a change in the frequency of the signal with a higher frequency by a predetermined amount, provides a control signal for controlling the safety-relevant device to the predetermined safe state.

10. Safety apparatus as claimed in Claim 9, **characterised in that**
the demodulator (830) comprises the following features:
a high-pass filter (832) and a first low-pass filter (833) whose respective input is connected to the output of the first device (820) controlled by a microprocessor,
a first monostable multivibrator (834) which comprises a reset input and a signal input which is connected to the output of the high-pass filter,
a second low-pass filter (837) whose input is connected to the negated output of the first monostable multivibrator (834),
a second monostable multivibrator (838) whose signal input is connected to the output of the first low-pass filter (833) and whose reset input is connected to the output of the second low-pass filter (837), and
a third monostable multivibrator (831) whose signal input is connected to the output of the input stage (760) and whose reset input is connected to the negated output of the second monostable multivibrator (838).

11. Safety apparatus as claimed in any one of Claims 1 to 10, **characterised in that**
the first control device (770; 820) controlled by a microprocessor is software-based and the second control device (780; 840) is hardware-based.

12. Safety apparatus as claimed in any one of Claims 1 to 11, **characterised in that**
the input signal is a binary process signal.

13. Safety apparatus as claimed in any one of Claims 1 to 121 [*sic*], **characterised in that**
the second control device (780; 840) comprises a microprocessor.

## Revendications

1. Dispositif de sécurité pour le contrôle multicanal d'un appareil de sécurité, comprenant un premier appareil de commande (770 ; 820) commandé par microprocesseur, qui présente un appareil de génération de signaux (772 ; 822) pour générer un signal de contrôle, un second appareil de commande (780 ; 840), un étage d'entrée (760) relié au premier appareil (770 ; 820) commandé par microprocesseur et au second appareil de commande (780 ; 840), lequel étage est conçu pour moduler un signal d'entrée avec le signal de commande arrivant du premier appareil de commande (770 ; 820) commandé par microprocesseur, le premier appareil de commande (770 ; 820) commandé par microprocesseur et/ou le second appareil de commande (780 ; 840) commandant en réaction au signal d'entrée modulé l'appareil de sécurité en cas d'apparition d'une erreur dans un état sûr prédéfini.

2. Dispositif de sécurité selon la revendication 1,
**caractérisé en ce que**
l'appareil de génération de signaux génère le signal de contrôle en fonction de la prise en charge d'au moins un programme important au niveau de la sécurité par le premier appareil de commande (770 ; 820) commandé par microprocesseur.

3. Dispositif de sécurité selon la revendication 1 ou 2,
**caractérisé en ce que**
le premier appareil de commande (770 ; 820) commandé par microprocesseur et le second appareil de commande (780 ; 840) sont reliés à un étage de sortie (790) et présentent chacun un appareil pour l'activation ou la désactivation de l'étage de sortie (790).

4. Dispositif de sécurité selon la revendication 3,
**caractérisé en ce que**
l'appareil d'activation/désactivation du premier appareil de commande (770 ; 820) commandé par microprocesseur présente un interrupteur (776 ; 828) pouvant être relié à la masse et l'appareil d'activation/désactivation du second appareil de commande (780 ; 840) présente un interrupteur (782 ; 850) pouvant être relié à une tension d'alimentation.

5. Dispositif de sécurité selon la revendication 3 ou 4,
**caractérisé en ce que**
l'étage de sortie (790) est au moins un appareil de commutation (795), en particulier un relais.

6. Dispositif de sécurité selon l'une quelconque des revendications 1 à 5,
**caractérisé en ce que**
le premier appareil de commande (770 ; 820) commandé par microprocesseur présente un appareil pour le contrôle de l'étage d'entrée et/ou du second appareil de commande et pour générer un signal d'erreur, et
**en ce que**
le premier appareil de commande (770 ; 820) commandé par microprocesseur commande en réaction au signal d'erreur l'appareil de sécurité dans un état sûr prédéfini.

7. Dispositif de sécurité selon l'une quelconque des revendications 1 à 6,
**caractérisé en ce que**
l'étage d'entrée (760) présente un dispositif d'enchaînement (762) logique, en particulier une porte ET pour la modulation du signal d'entrée avec le signal de contrôle.

8. Dispositif de sécurité selon l'une quelconque des revendications 1 à 7,
**caractérisé en ce que**
le premier appareil de commande (820) commandé par microprocesseur présente un modulateur (824) pour la modulation du signal de contrôle avec un signal dont la fréquence est supérieure à la fréquence du signal de contrôle, **en ce que** l'étage d'entrée (760) est conçu pour la modulation du signal de contrôle modulé avec le signal d'entrée, **en ce que**
le second appareil de commande (840) présente un démodulateur (830) qui génère en réaction au signal d'entrée modulé venant de l'étage d'entrée (760) et au signal de contrôle modulé venant du premier appareil de commande (820) commandé par microprocesseur, en cas d'apparition d'une erreur, un signal de commande qui commande l'appareil de sécurité dans l'état sûr prédéfini.

9. Dispositif de sécurité selon la revendication 8,
**caractérisé en ce que**
le démodulateur (830) présente un filtre à suppression de bande et au moins un dispositif de commutation (831), en particulier un monoflop, qui, en cas de variation de la fréquence du signal avec une fréquence supérieure d'une valeur prédéfinie, fournit un signal de commande pour commander l'appareil de sécurité dans l'état sûr prédéfini.

10. Dispositif de sécurité selon la revendication 9,
**caractérisé en ce que**
le démodulateur (830) présente les caractéristiques suivantes :
un filtre passe-haut (832) et un premier filtre passe-bas (833), dont l'entrée respective est reliée à la sortie du premier appareil (820) commandé par microprocesseur,
un premier monoflop (834), qui présente une entrée de redémarrage et une entrée de signal qui est reliée à la sortie du filtre passe-haut,
un second filtre passe-bas (837) dont l'entrée est reliée à la sortie inversée logiquement du premier monoflop (834),
un second monoflop (838), dont l'entrée de signal est reliée à la sortie du premier filtre passe-bas (833) et dont l'entrée de redémarrage est reliée à la sortie du second filtre passe-bas (837), et
un troisième monoflop (831), dont l'entrée de signal est reliée à la sortie de l'étage d'entrée (760) et dont l'entrée de redémarrage est reliée à la sortie inversée logiquement du second monoflop (838).

11. Dispositif de sécurité selon l'une quelconque des revendications 1 à 10,
**caractérisé en ce que**
le premier appareil de commande (770 ; 820) commandé par microprocesseur est basé sur le logiciel et le second appareil de commande (780 ; 840) est basé sur le matériel.

12. Dispositif de sécurité selon l'une quelconque des revendications 1 à 11,
**caractérisé en ce que**
le signal d'entrée est un signal de processus binaire.

13. Dispositif de sécurité selon l'une quelconque des revendications 1 à 121, **caractérisé en ce que**
le second dispositif de commande (780 ; 840) présente un microprocesseur.
